Europäisches Patentamt

European Patent Office

Office européen des brevets

(19)

(11) **EP 0 420 748 B1**

(12) # FASCICULE DE BREVET EUROPEEN

(45) Date de publication et mention
de la délivrance du brevet:
**27.01.1999 Bulletin 1999/04**

(51) Int Cl.6: **H01L 21/336**

(21) Numéro de dépôt: **90402651.5**

(22) Date de dépôt: **26.09.1990**

(54) **Procédé de fabrication d'un circuit intégré MIS haute tension**

Verfahren zur Herstellung einer Hochspannungs-MIS-integrierten Schaltung

Process of fabricating a high-tension MIS integrated circuit

(84) Etats contractants désignés:
**DE ES FR GB IT NL**

(30) Priorité: **28.09.1989 FR 8912697**

(43) Date de publication de la demande:
**03.04.1991 Bulletin 1991/14**

(73) Titulaire: **COMMISSARIAT A L'ENERGIE ATOMIQUE**
**75015 Paris Cédex 15 (FR)**

(72) Inventeur: **Deleonibus, Simon**
**F-38640 Claix (FR)**

(74) Mandataire: **Lhoste, Catherine et al**
**BREVATOME**
**25, rue de Ponthieu**
**75008 Paris (FR)**

(56) Documents cités:
- **EXTENDED ABSTRACTS/SPRING MEETING, vol. 88-1, 15 - 20 mai 1988, pages 301-302, résumé no. 193, Princeton, NJ, US; T. MAKINO et al.: "A stacked-source-frain- MOSFET using selective epitaxy"**
- **IEEE JOURNAL OF SOLID-STATE CIRCUITS, vol. SC-17, no. 2, avril 1982, pages 161- 165, IEEE, New York, US; T. SHIBATA et al.: "An optimally designed process for submicrometer MOSFET's"**
- **IBM TECHNICAL DISCLOSURE BULLETIN, vol. 25, no. 3B, août 1982, pages 1396-1397, New York, US; H.J. GEIPEL et al.: "Process for simultaneously making silicide gate, source and drain electrodes"**
- **IEEE INTERNATIONAL ELECTRON DEVICES MEETING, 1988, pages 450-453, IEEE, New York, US; V.V. LEE et al.: "A selective tungsten local interconnect technology"**

## Description

La présente invention a pour objet un procédé de fabrication d'un circuit intégré supportant des hautes tensions d'alimentation, comportant des transistors MIS à double implantation. Elle s'applique en particulier dans le domaine des circuits intégrés de type nMOS, pMOS, CMOS et BICMOS et plus spécialement aux circuits intégrés dont les largeurs des grilles des transistors sont inférieures au micromètre voire même inférieures à 0,2 micromètre.

Ces circuits submicroniques sont en particulier des microprocesseurs, des microcontrôleurs, des mémoires, des circuits d'application spécifique (ASIC), etc.

Avec la réduction des dimensions critiques des circuits intégrés, et plus particulièrement de la largeur de la grille des transistors MIS, on a été amené à modifier les procédés de réalisation des sources et drains de ces transistors.

En effet, plus la largeur de la grille est petite, plus la diffusion latérale de l'implantation source-drain sous la grille devient importante, et donc gênante, et plus le transistor MIS est sensible au phénomène de perçage entre la source et le drain, correspondant au courant de fuite entre la source et le drain pour une tension de grille nulle. Enfin, la diminution de cette largeur de grille entraîne un vieillissement prématuré du transistor MIS par injection de porteurs chauds dans l'isolant de grille. Ce phénomène est d'autant plus important que la concentration de dopants aux bords de la grille du transistor est élevée.

Pour toutes ces raisons, les transistors de type n et aussi de type p sont maintenant réalisés avec un procédé à double implantation, appelé LDD (Low Doped Drain en terminologie anglo-saxonne), qui permet pour les technologies dont la largeur de la grille est typiquement inférieure à 2 micromètres de résoudre les problèmes mentionnés ci-dessus.

Ce procédé devient absolument indispensable et primordial dans les technologies submicroniques.

Ce procédé est en particulier décrit dans le document EP-A-0 054 117 d'IBM. Il consiste essentiellement à former la grille des transistors dans une couche de silicium polycristallin, à oxyder thermiquement le substrat et la grille des transistors, à effectuer une première implantation à faible dose, à former des espaceurs de part et d'autre de la grille des transistors puis à effectuer une seconde implantation à forte dose pour former les sources et drains à double jonction des transistors.

La première implantation à faible dose permet une diminution considérable de la concentration de dopant à l'aplomb de la grille des transistors et donc de résoudre en partie les problèmes électriques mentionnés ci-dessus. La seconde implantation à forte dose est nécessaire pour remplir le rôle de source et de drain des transistors car la résistance des jonctions obtenues par l'implantation à faible dose est trop importante.

Afin d'éviter que cette implantation à forte dose ne se superpose à la zone d'implantation à faible dose, il faut l'écarter physiquement du bord de la grille. Ceci est réalisé en effectuant la seconde implantation à travers les espaceurs ou bandes d'espacement.

Ces bandes d'espacement sont obtenues par dépôt isotrope d'une couche d'isolant sur l'ensemble de la structure, puis par gravure pleine plaque de cette couche d'isolant afin de former sur les flancs de la grille les espaceurs.

Lors de la réalisation des espaceurs, on constate généralement une consommation importante (plusieurs dizaines de nm) de l'isolant de champ (généralement de l'oxyde de champ) utilisé pour l'isolation électrique des transistors. Cette consommation de l'isolant de champ modifie ses propriétés électriques, ce qui peut favoriser la création de transistors parasites dans ces isolations.

Par ailleurs, le procédé d'IBM ci-dessus ne permet pas l'obtention de circuits intégrés MIS fonctionnant à haute tension d'alimentation. En outre, les transistors obtenus ont une faible transconductance.

Par tension d'alimentation élevée, il faut comprendre des tensions d'alimentation de 8V pour des largeurs de grille de transistors de 500 nm, des tensions de 5V pour des largeurs de grille de 300 nm et des tensions de 3V pour des largeurs de grille inférieures à 200 nm.

Pour remédier à ces inconvénients, R. IZAWA et al. ont proposé une modification du procédé IBM qui est décrite dans l'article IEDM 87, p.38-41 "The impact of gate-drain overlapped LDD (GOLD) for deep submicron VLSI'S". Dans ce procédé on forme successivement sur l'oxydation thermique du substrat une première couche de silicium polycristallin, un second oxyde thermique et une seconde couche de silicium polycristallin. On grave ensuite à travers un masque isolant cette seconde couche de silicium polycristallin, puis on effectue la première implantation à faible dose dans le substrat à travers la seconde couche d'oxydation thermique, la première couche de silicium polycristallin et la première couche d'oxydation thermique. Après l'implantation à faible dose, on forme les espaceurs par dépôt d'une couche d'oxyde sur l'ensemble de la structure, puis gravure pleine plaque de cette couche d'oxyde.

En utilisant les espaceurs comme masque, on effectue une gravure de la première couche de silicium polycristallin puis une oxydation des flancs gravés de cette première couche de silicium. Seulement alors, on effectue la seconde implantation à forte dose.

L'utilisation d'une première couche de silicium polycristallin permet un débordement de la grille du transistor sur les zones de source et drain faiblement implantées, diminuant encore la résistance électrique de ces zones à faible implantation. En outre, ce procédé permet d'augmenter la transconductance des transistors ainsi que le courant dans leur canal.

Malheureusement, les transistors obtenus ont encore une trop faible tenue au perçage entre la source et le drain, limitant ainsi la tension d'alimentation appliquée à ces transistors. La faible tenue au perçage des transistors "GOLD" tient au fait que les transistors n+pn+ ou p+np+ sont enterrés sous le canal des transistors respectivement n-pn- et p-np-.

En outre, ce procédé présente des difficultés de mise en oeuvre. En particulier la gravure de la seconde couche de silicium polycristallin nécessite une sélectivité supérieure à 100 par rapport à la seconde couche d'oxyde de silicium compte tenu de la faible épaisseur de la couche d'oxyde nécessaire pour éviter l'obtention d'une grille flottante, ce qui est actuellement difficile à réaliser avec les techniques de gravure utilisées.

On connaît également par le document : Extended abstracts/Spring meeting, vol. 88-1, 15-20 mai 1988, résumé n° 193, Princeton, NJ, US, pages 301, 302, un procédé de fabrication d'un transistor de type MOSFET dans un substrat semi-conducteur, dont les régions de drain et de source sont obtenues par une double implantation.

Le document IEEE Journal of solid State Circuits, vol. SC-17, n° 2, Avril 1982, IEEE, New-York, US, pages 161-165 montre par ailleurs un procédé de fabrication de transistors MOSFET faisant appel à une technique de siliciuration auto-alignée.

La présente invention a pour objet un nouveau procédé de fabrication d'un circuit intégré MIS supportant des tensions d'alimentation élevées et comportant des transistors à double implantation, permettant de remédier aux différents inconvénients mentionnés ci-dessus. En particulier, ce procédé permet la réalisation de transistors de largeur de grille submicronique, voire inférieure à 200 nm, ayant une meilleure tenue au perçage que les transistors fabriqués selon l'art antérieur.

Par ailleurs, ce procédé est relativement simple à réaliser et ne comporte aucune étape critique. Il permet en particulier la réalisation de contacts débordant sur les sources et drains des transistors sans utilisation d'artifice tel que l'implantation d'ions dans les trous de contact, supplémentaires, nécessaire dans les procédés connus.

De façon plus précise, l'invention a pour objet un procédé de fabrication d'un circuit intégré telque défini par la revendication 1.

Par couche conductrice il faut comprendre une couche conductrice au propre sens du terme mais aussi une couche semi-conductrice. En particulier dans une technologie sur silicium, cette couche conductrice peut être une couche de silicium polycrystallin, dopé n ou p suivant le type de transistor à réaliser, une couche de siliciure d'un métal de transition tel que du siliciure de cobalt ou du siliciure de titane ou encore une couche de silicium dopé, partiellement siliciure en surface.

L'épitaxie d'une couche conductrice sur les grilles procure un certain nombre d'avantages. En particulier, elle permet une implantation forte dose des grilles de manière auto-positionnée (self-aligned en terminologie anglo-saxonne) en même temps que l'implantation forte dose des sources et drains, une amélioration de l'interconnexion des grilles en diminuant la résistance de connexion ainsi qu'un gain de temps et de coût de fabrication par diminution des étapes à risques par rapport à l'art antérieur.

Les transistors MIS obtenus par le procédé de l'invention ont une meilleure tenue au perçage que ceux obtenus par le procédé de IZAWA cité précédemment grâce à l'utilisation de la couche conductrice épitaxiée qui suspend les régions n+ ou p+, de forte implantation, des régions de source et drain au-dessus du niveau du canal des transistors. La profondeur de jonction effective dans le substrat diminue alors, et il n'y a plus de transistor bipolaire parasite n+pn+ ou p+np+ enterré, en parallèle avec le transistor bipolaire n-pn- ou p-np-.

Bien que l'invention s'applique particulièrement bien à une technologie sur silicium, elle s'applique aussi à une technologie sur GaAs, InP, HgCdTe.

Par isolation latérale, il faut comprendre aussi bien une isolation de surface du type oxyde de champ qu'une isolation en profondeur par tranchées d'isolement.

Les transistors MIS obtenus selon le procédé de l'invention peuvent supporter des tensions d'alimentation élevées (5V par exemple pour des largeurs de grille de 300 nm). En effet, de la même manière que dans la structure GOLD de IZAWA, le champ électrique créé à proximité du canal est faible du fait du dopage graduel obtenu sous la grille des transistors. Ceci permet d'augmenter la tension d'avalanche de la diode de drain et d'assurer une meilleure fiabilité du composant lorsque l'on exerce sur son drain de fortes tensions.

Par ailleurs, la gravure de la couche semi-conductrice pour former les grilles des transistors, après la réalisation des bandes d'espacement, assure une protection des isolations latérales lors de la réalisation de ces bandes d'espacement. Cette protection est particulièrement intéressante lorsque les isolations latérales et les bandes d'espacement sont réalisées en un même matériau, par exemple en oxyde de silicium.

De façon connue les bandes d'espacement sont formées par dépôt isotrope d'une couche isolante sur l'ensemble de la structure puis par gravure sélective et anisotrope de cette couche. Dans ce contexte, la gravure de la couche semi-conductrice pour former les grilles, après la réalisation des espaceurs, permet d'utiliser cette couche semi-conductrice comme couche d'arrêt de gravure des espaceurs. En outre, cette couche semi-conductrice assure la protection des régions de source et drain en fin de gravure des espaceurs (la gravure des espaceurs dans l'art antérieur s'arrêtant dans le substrat semi-conducteur); ceci permet alors de supprimer l'étape de nettoyage utilisée dans l'art antérieur pour éliminer les résidus de gravure des espaceurs sur les zones actives et supprimer ainsi tout risque de contamination de ces zones lors de cette étape de gravure.

De façon avantageuse, on dépose un matériau conducteur entre les étapes l) et m) du procédé cidessus, de façon sélective sur la couche conductrice épitaxiée par rapport aux bandes d'espacement, aux isolations latérales et au second isolant pour former les shunts des grilles, des sources et des drains.

L'ordre des étapes du procédé de l'invention permet la formation des shunts des grilles en même temps que celle des sources et des drains.

La réalisation de shunts sur les sources, drains et grilles des transistors avant la réalisation de leurs contacts électriques, permet d'assurer une bonne protection des diodes sources et drains en bordure des isolations latérales. En particulier, ces shunts permettent la réalisation de contacts électriques débordant sur les régions de sources et drains sans étape particulière. En outre, ces shunts améliorent les contacts électriques des connexions du circuit sur les zones de source et drain ainsi que sur les grilles des transistors et facilitent la formation de ces contacts.

Grâce à ces shunts, il est possible de réaliser les connexions électriques du circuit intégré en déposant sur l'ensemble de la structure obtenue en l) après réalisation de ces shunts, une couche d'isolement ; en formant des trous de contact dans cette couche d'isolement en regard des grilles, des sources et des drains à connecter et en déposant un matériau conducteur de façon sélective dans les trous de contact par rapport à la couche d'isolement. Dans ce mode de réalisation, l'utilisation de shunts sur les sources et drains sert en particulier de "germe" à la croissance de la couche de matériau conducteur déposée sélectivement dans les trous de contact.

Bien entendu, il est aussi possible de déposer ce matériau conducteur sur l'ensemble de la couche d'isolement et de graver ce matériau selon un profil déterminé pour réaliser ces connexions.

Les matériaux conducteurs utilisés pour constituer le shunt des sources, des drains et des grilles des transistors ainsi que les connexions du circuit intégré sont en particulier du tungstène déposé à basse température (250 à 450°C environ), selon la technique de dépôt chimique en phase vapeur basse pression (LPCVD).

Le dépôt sélectif de tungstène pour la réalisation des interconnexions d'un circuit intégré est en particulier décrit dans l'article V.V. Lee et al. IEDM 88, p. 450-453, "A selective CVD tungsten local interconnect technology".

Selon l'invention, il est aussi possible de réaliser les interconnexions du circuit intégré et les shunts des sources, drains et grilles des composants par épitaxie de silicium dopé, par dépôt LPCVD de siliciure d'un métal de transition tel que du $CoSi_2$ ou $TiSi_2$ ou par électrophorèse de métal tel que le platine, le palladium, le cuivre.

Selon l'invention, le masque servant à marquer les grilles des transistors à réaliser peut être constitué d'une ou deux couches de matériau et la couche, formée directement sur la couche semi-conductrice dans laquelle peuvent être réalisées les grilles de transistors, doit être apte à être gravée sélectivement par rapport aux isolations latérales, au premier isolant, à ladite couche semi-conductrice, au second isolant et aux bandes d'espacement. En particulier, le matériau directement au contact de la couche semi-conductrice est du nitrure de silicium lorsque le premier isolant, le deuxième isolant, les bandes d'espacement et les isolations latérales sont en oxyde de silicium et lorsque la couche semi-conductrice est en silicium polycristallin.

Pour des premier isolant, second isolant, isolations latérales, et bandes d'espacement en nitrure de silicium, le matériau formé directement sur la couche destinée aux grilles est de l'oxyde de silicium.

Dans un empilement bi-couche, la couche supérieure est en $SiO_2$ quand la couche inférieure est en $Si_3N_4$ et inversement.

De façon avantageuse, on effectue un recuit de la structure, à une température allant de 800 à 1000°C en technologie silicium, après la seconde implantation, afin de faire diffuser les ions implantés dans le substrat et la couche conductrice épitaxiée, ainsi que de les activer. Lorsque les étapes de fabrication du circuit intégré, postérieures à la seconde implantation sont effectuées à haute température (supérieure à 800°C pour le silicium), il est possible de supprimer cette étape de recuit. Comme étape haute température, on peut citer la réalisation de la couche d'isolement des connexions électriques.

D'autres caractéristiques et avantages de l'invention ressortiront mieux de la description qui va suivre, donnée à titre illustratif et non limitatif, en référence aux dessins annexés, dans lesquels :

- les figures 1A à 1H illustrent schématiquement, en coupe longitudinale, les différentes étapes du procédé conforme à l'invention,
- les figures 2 et 3 illustrent une variante du procédé conforme à l'invention,
- les figures 4 et 5 illustrent des positions limites des connexions des transistors obtenus par le procédé conforme à l'invention.

La description des figures qui suit se rapporte à la fabrication de transistors MOS à double implantation et à canal n dans un substrat en silicium de type p. Bien entendu, comme on l'a dit précédemment, l'invention est d'application beaucoup plus générale et s'applique en particulier à des transistors à canal p et à la fabrication de circuit CMOS comportant des transistors à canal n et des transistors à canal p intégrés sur un même substrat ainsi qu'à des circuits BICMOS comportant, en plus, des transistors bipolaires.

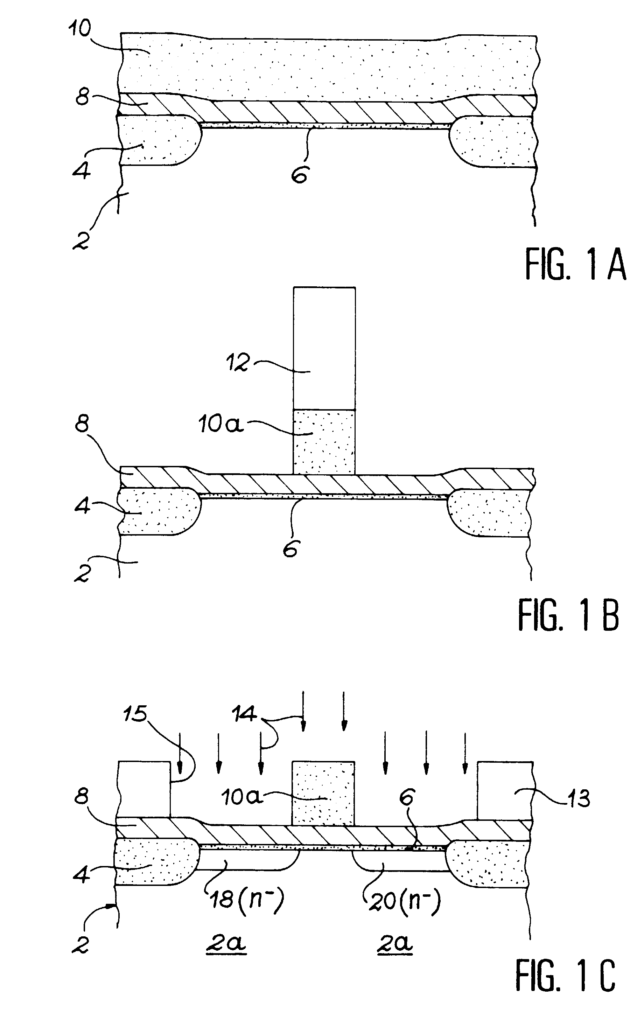

De façon connue et comme représenté sur la figure 1A, on forme tout d'abord sur un substrat en silicium monocristallin 2 de type p, un oxyde de champ 4 par oxydation thermique localisée du substrat selon la technique LOCOS. Cet oxyde de champ 4 sert à isoler électriquement les différents composants actifs du circuit intégré. Il présente une épaisseur de 600nm environ.

On forme ensuite, entre l'oxyde de champ 4, une mince couche d'oxyde de silicium 6 qui servira d'oxyde de grille des transistors. Cet oxyde de grille est obtenu par oxydation thermique du substrat ; il présente une épaisseur de 25 à 30 nm.

On dépose ensuite sur l'ensemble de la structure une couche de silicium polycristallin 8 intentionnellement non dopé. Cette couche est obtenue en particulier par dépôt chimique en phase vapeur basse température et présente une épaisseur de 50 à 100 nm. On dépose ensuite une couche 10 de nitrure de silicium de 300 nm d'épaisseur, par dépôt chimique en phase vapeur (CVD).

On forme alors, comme représenté sur la figure 1B, un masque photolithographique positif 12 assurant le masquage de la grille des transistors à réaliser dans la couche de silicium 8. On effectue ensuite une gravure de la couche 10 sur toute son épaisseur avec arrêt dans la couche 8 de silicium. La couche 8 joue ainsi le rôle de couche d'arrêt de gravure et de couche tampon entre la couche d'oxyde 6 et la couche 10.

Cette gravure est réalisée de façon sélective par rapport à la couche de silicium 8 selon une technique de gravure ionique réactive ; le gaz réactif est par exemple un mélange de $CHF_3,C_2F_6$. On obtient ainsi un masque de gravure et d'implantation référencé 10a. Ce masque 10a assure un auto-positionnement des jonctions faible dose et forte dose par rapport aux grilles des transistors et aux espaceurs.

Après élimination du masque de résine 12 par plasma d'oxygène, on forme, comme représenté sur la figure 1C dans le cas de la réalisation du circuit intégré à différents types de transistors, un nouveau masque lithographique de résine 13 définissant l'emplacement de la source et du drain des transistors d'un type donné. A cet effet, ce masque comporte des ouvertures 15 en regard des régions 2a du substrat dans lesquelles doivent être réalisés les transistors. Dans le cadre de la réalisation des circuits CMOS, ce masque 13 sert en particulier à masquer les régions du substrat destinées aux transistors pMOS.

On effectue alors une première implantation ionique 14 de type n-, à faible dose, dans les régions 2a du substrat non masquées puis une implantation à forte dose dans la couche de silicium 8 en utilisant les masques 13 et 10a comme masque d'implantation.

L'implantation n- dans le substrat peut être effectué avec du phosphore ou de l'arsenic à des doses de $1x10^{12}$ à $5x10^{13}$ ions/cm$^2$ aux énergies de 50 à 100 keV. L'implantation n+ à forte dose dans la couche de silicium 8 peut être réalisée aussi avec du phosphore ou de l'arsenic à des doses de $1x10^{14}$ à $1x10^{15}$ ions/cm$^2$ (soit des doses 20 à 100 fois plus élevées) et à des énergies de 10 à 25 keV ; les énergies d'implantation étant directement liées à la profondeur d'implantation, le dopage de la couche 8 est effectué avec des énergies plus faibles que celles utilisées pour le dopage du substrat, par exemple de 4 à 5 fois plus faibles.

L'implantation à faible dose dans les régions 2a du substrat assure la formation des premières jonctions de source 18 et de drain 20 des transistors, ces sources et drains étant de type n-.

On élimine ensuite le masque de résine 13 par plasma d'oxygène.

Dans le cadre de la réalisation d'un circuit CMOS, on réalise ensuite un autre masque d'implantation masquant les transistors à canal n réalisés et comportant des ouvertures en regard des transistors à canal p à réaliser en vue d'effectuer une implantation à faible dose de type p- dans le substrat et une implantation à forte dose p+ dans la couche de silicium 8.

L'implantation p- peut être réalisée avec des ions de bore ou $BF_2^+$ aux mêmes doses que celles utilisées pour l'implantation n-, mais en utilisant des énergies de 10 à 70 keV. Ensuite, on effectue l'implantation p+ dans la couche 8 avec des ions de bore ou $BF_2^+$ aux mêmes doses que l'implantation n+ dans la couche 8, mais à des énergies de 10 à 50 keV. Comme pour les transistors à canal n, ces implantations p- et p+ sont effectuées en utilisant, en plus du masque lithographique de résine, un masque de nitrure de silicium réalisé en même temps que le masque 10a, masquant le canal des transistors de la même façon que le masque 10a. Ce masque de résine est enlevé après l'implantation p+ de la couche 8.

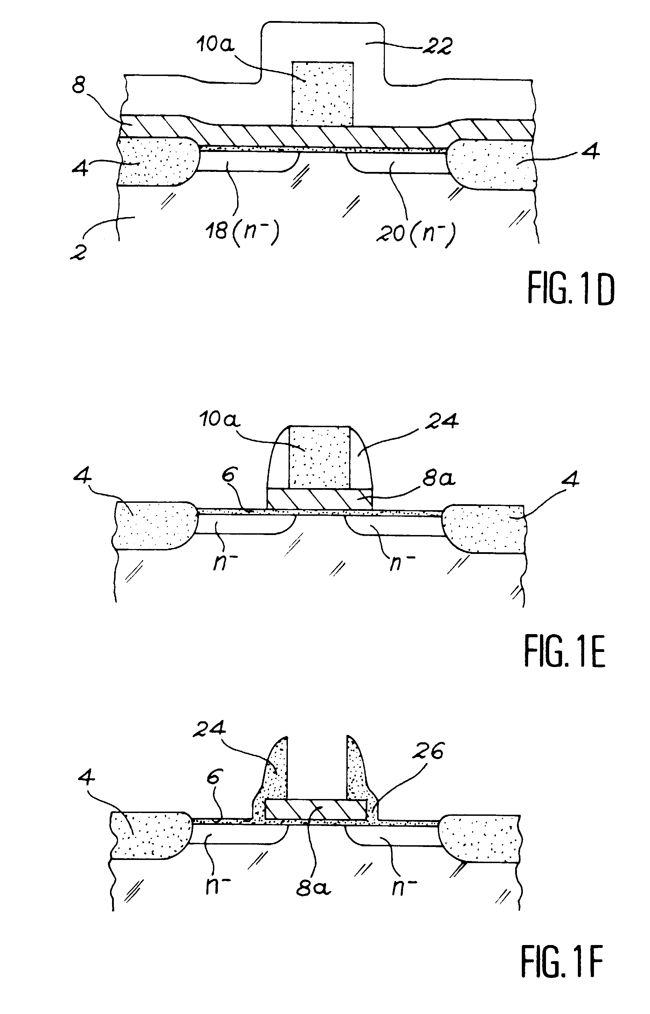

La première implantation à forte dose de la couche de silicium 8 permet d'assurer un dopage de cette couche jusqu'à l'interface 8-6 silicium-oxyde de grille et en particulier sous les bandes d'espacement ou espaceurs réalisés ultérieurement (figure 1E). Ce dopage forte dose de la couche 8 permet en outre d'assurer un bon fonctionnement à haute fréquence des transistors.

On dépose ensuite sur l'ensemble de la structure obtenue précédemment une couche d'isolant 22 destinée à être gravée sélectivement par rapport à la couche de silicium 8.

Cette couche 22 est en particulier une couche d'oxyde de silicium déposée par dépôt chimique en phase vapeur basse pression (LPCVD), cette technique de dépôt assurant l'homogénéité de l'épaisseur de la couche 22. Cette épaisseur vaut environ 100 à 200 nm. On obtient ainsi la structure représentée sur la figure 1D.

On effectue alors une gravure anisotrope de la couche d'oxyde 22, la couche de silicium 8 servant de couche d'arrêt de gravure. Cette gravure est du type gravure pleine plaque (c'est-à-dire sans masque). Elle est réalisée en mode ionique réactif en utilisant un plasma de tri- ou tétra-fluorométhane par exemple.

On obtient ainsi sur les flancs du masque 10a des bandes ou liserés isolants 24 jouant le rôle d'espaceurs, comme représenté sur la figure 1E.

Ces espaceurs 24 sont des résidus volontaires résultant des surépaisseurs d'oxyde sur les flancs du masque 10a.

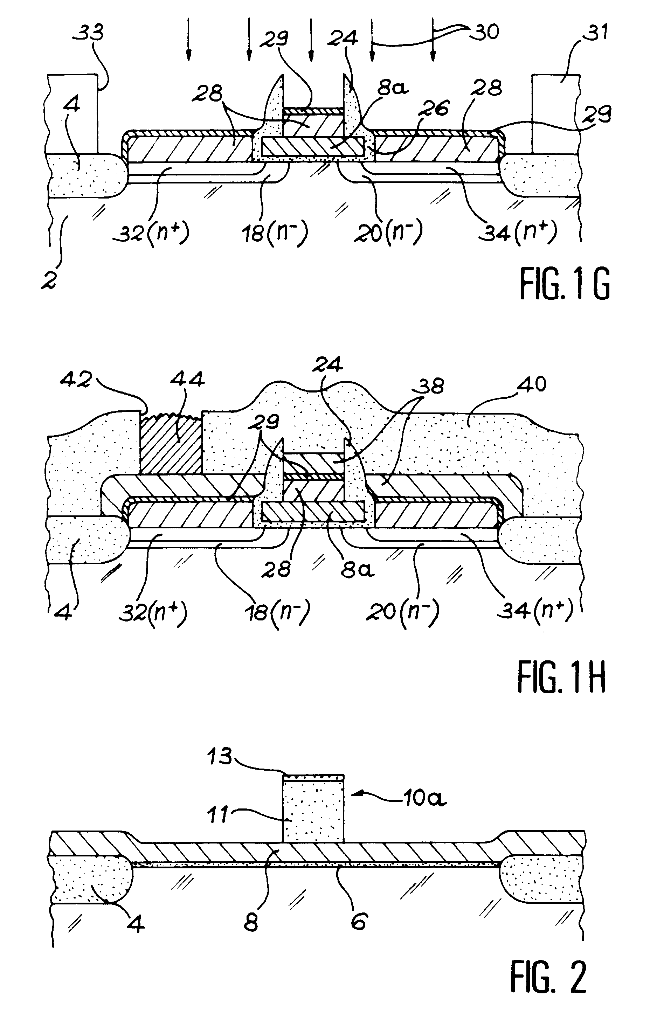

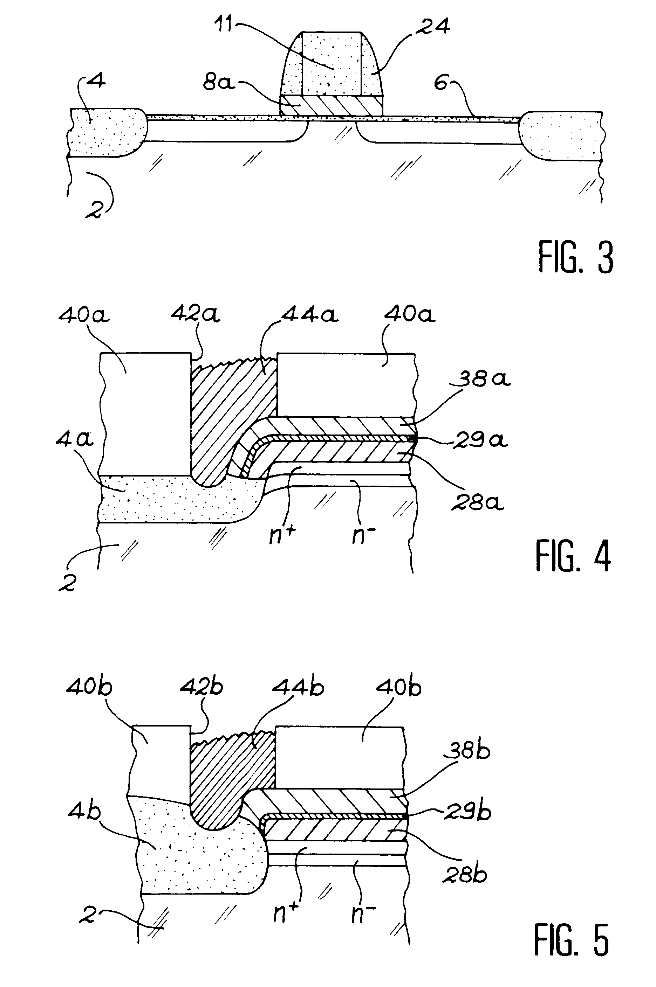

Afin de garder intact le masque 10a lors de la gravure des bandes d'espacement 24, il est possible d'utiliser un masque de gravure 10a bicouche. Cette variante est représentée sur les figures 2 et 3. A cet effet, lors du dépôt des couches destinées à former le masque 10a, on dépose successivement une couche 11 de Si₃N₄ de 300 nm directement sur la couche sem-conductrice 8 par LPCVD et une couche 13 de SiO₂ de 30 nm par dépôt chimique en phase vapeur basse pression, par pyrolyse de tétraéthylorthosilicate (TEOS) ou à basse température (LTO).

Le masque de gravure bicouche 10a (figure 2) est réalisé comme précédemment par gravure ionique réactive en utilisant un plasma de tri- ou tétrafluorométhane pour la couche supérieure 13 en SiO₂ et un mélange de $CHF_3, C_2F_6$ pour la couche inférieure 11 en Si₃N₄.

Du fait que la couche supérieure 13 est réalisée en un matériau de même nature que celui destiné aux espaceurs 24, la couche supérieure 13 est supprimée, lors de la gravure des espaceurs 24 (figure 3).

L'étape suivante du procédé, comme représenté sur la figure 1E, consiste à graver la couche semi-conductrice 8 de façon à en éliminer les régions non recouvertes par le masque 10a mais aussi par les espaceurs 24. On obtient ainsi la grille 8a des transistors.

Cette gravure doit être sélective par rapport aux bandes d'espacement 24, aux isolations latérales 4 et par rapport à l'oxyde 6, ce dernier servant en outre de couche d'arrêt de gravure. Cette gravure de la couche 8 peut être réalisée de façon ionique réactive en utilisant un plasma d'hexafluorure de soufre pour une couche en silicium, ce type de gravure ayant des caractéristiques d'anisotropie élevées.

La gravure de la couche de silicium après la réalisation des espaceurs permet d'éviter une gravure en surface de l'oxyde de champ 4.

On effectue ensuite une réoxydation des régions de source et drain des transistors entraînant en particulier l'oxydation latérale 26 de la grille 8a en silicium des transistors. La couche d'oxyde formé a une épaisseur de 10 à 20 nm.

On effectue alors, comme représenté sur la figure 1F, l'élimination du masque 10a de façon sélective vis-à-vis des espaceurs 24, des isolants 4, 6 et 26 et des grilles 8a. Pour un masque en nitrure de silicium, on utilise en particulier de l'acide ortho-phosphorique chaud pour cette élimination.

L'étape suivante du procédé consiste, comme représenté sur la figure 1G, à éliminer par gravure anisotrope les régions de l'oxyde 6 mises à nu lors de la gravure de la couche silicium 8.

Cette élimination est réalisée avec une gravure sèche anisotrope avec arrêt de gravure sur le substrat en silicium. Cette gravure est effectuée de façon sélective par rapport au silicium, par exemple en utilisant du tri- ou tétrafluorométhane. Cette élimination de l'oxyde au-dessus des régions de source et drain entraîne une légère érosion des espaceurs 24 et de l'oxyde de champ (de quelques nm), non nuisible au fonctionnement ultérieur des transistors et à leurs étapes ultérieures de fabrication.

Après un nettoyage approprié des surfaces de silicium exposées (c'est-à-dire les régions de source, de drain et la grille 8a du transistor), on procède à l'épitaxie d'une couche conductrice 28 de façon sélective sur les régions de source et drain et sur les grilles 8a par rapport à l'oxyde de champ 4, aux espaceurs 24 et à l'isolation latérale 26 des grilles 8a. Cette couche 28 a une épaisseur de 100 nm environ. Elle est en particulier constituée de silicium à forte densité de défauts, c'est-à-dire quasi-amorphe ou comportant des micro-cristallines, de façon à favoriser la formation de jonctions fines, lors de l'implantation ultérieure, et ce avec un bon contrôle de la profondeur des jonctions ; l'épitaxie du silicium est obtenue à partir de la décomposition thermique de SiH₄.

Avantageusement, on peut siliciurer partiellement ou totalement la couche de silicium 28. Une siliciuration partielle permet, comme représenté sur la figure 1G, l'obtention d'une couche 29 de surface. Cette couche permet de diminuer la résistance de contact entre la couche 28 et les connexions du circuit. Cette couche 29 est obtenue par siliciuration auto-positionnée (ou auto-alignée) sur les régions de source, drain et grille en utilisant des métaux de transition tels que le titane ou le cobalt.

Cette siliciuration consiste à déposer une couche métallique de Ti ou Co sur la couche 28 et à chauffer la structure obtenue entre 500 et 800°C pour que le métal réagisse chimiquement avec le silicium sous-jacent et à éliminer sélectivement le métal déposé ailleurs que sur la couche 28.

On effectue alors une implantation d'ions 30 dans les couches 28 et 29 mais aussi dans les régions sous-jacentes de source et de drain et dans les grilles 8a. Cette implantation est une implantation forte dose, c'est-à-dire que la dose est 10 à 50 fois plus forte que celle de l'implantation faible dose des régions de source et de drain. En particulier, on implante des ions de phosphore ou d'arsenic à des doses de $5 \times 10^{14}$ à $5 \times 10^{15}$ ions/cm² avec une énergie de 15 à 80 keV.

Cette implantation n+ est réalisée comme précédemment à l'aide d'un masque 31, identique au masque 13, comportant des ouvertures 33 en regard des transistors à canal n à réaliser et masquant le reste du circuit et en particulier les régions dans lesquelles doivent être réalisés des transistors à canal p pour des circuits intégrés CMOS.

Dans ce type de circuit, on effectue ensuite, après élimination du masque 31, une implantation de type p+ dans les transistors à canal p en utilisant un masque similaire au masque 31 comportant des ouvertures en regard des transistors à canal p et masquant alors les transistors à canal n réalisés. Cette implantation forte dose p+ est en particulier effectuée avec des ions de bore ou $BF_2^+$, à une énergie de 10 à 60 keV et des doses identiques à celles utilisées pour l'implantation n+.

L'implantation forte dose 30 est effectuée en utilisant, outre les masques de résine, les espaceurs 24 et les isolations latérales 26 des grilles 8a comme masque, permettant ainsi d'écarter physiquement les régions n+ (respectivement p+) de source et drain 32 et 34 du canal des transistors.

Les ions implantés en dernier lieu sont essentiellement localisés dans la couche épitaxiée de silicium 28 et la couche de siliciure 29. Aussi, pour assurer une diffusion de ces ions dans le substrat en vue d'obtenir les régions de source 32 et de drain 34 de type n+, et dans la grille 8a des transistors ainsi qu'une activation des ions implantés, on effectue un recuit de la structure obtenue ; ce recuit est réalisé soit au four à 900°C pendant 2 à 3 dizaines de minutes sous atmosphère d'azote, soit à l'aide d'un recuit rapide au moyen de lampes.

Lors du recuit d'implantation, la couche 28 épitaxiée et implantée sert de source de dopant pour les grilles et les régions de source et drain des transistors.

Grâce à l'implantation forte dose à travers les couches 28 et 29 conformément à l'invention et au recuit successif à cette implantation, on obtient des zones n+ (respectivement p+) noyées physiquement dans les zones n- (respectivement p-) et suspendues au-dessus du niveau du canal des transistors qui se trouve au niveau des régions n- (respectivement p-) des transistors.

En outre, grâce à la couche épitaxiée 28 servant de source de dopant, on obtient une meilleure tenue à l'avalanche de la diode de drain des transistors, de la même manière que dans la structure GOLD citée précédemment, mais aussi une meilleure tenue au perçage que les transistors de cette structure GOLD.

L'étape suivante du procédé consiste à déposer une couche conductrice 38 sélectivement sur la couche de siliciure 29 par rapport aux bandes d'espacement 24, comme représenté sur la figure 1H, permettant la réalisation des shunts de la grille, de la source et du drain de chaque transistor. Cette couche conductrice 38 est en particulier du tungstène déposé par LPCVD, à basse température, par décomposition de $WF_6$ et de $SiH_4$, comme décrit dans l'article de V.V. Lee cité précédemment. Cette couche conductrice 38 a une épaisseur d'environ 100 nm.

Les shunts des grilles, sources et drains obtenus ont une faible résistance, de l'ordre de 0,5 à 2 ohms/carré.

Les transistors MOS ainsi obtenus peuvent supporter des tensions d'alimentation élevées et en particulier de 5 V pour des grilles 8a de 300 nm de large.

Après le dépôt de façon sélective du matériau conducteur 38, on effectue le dépôt d'une couche d'isolement 40, en particulier d'oxyde de silicium, sur l'ensemble de la structure. Un aplanissement par fluage de cette couche 40 peut éventuellement être réalisé pour adoucir le passage de marche de la métallisation ultérieure des grilles et des interconnexions des régions de source et drain des transistors du circuit intégré.

Pour assurer la métallisation des grilles 8a et la réalisation des interconnexions du circuit, on effectue des ouvertures 42 dans la couche d'isolement 40 par gravure ionique réactive à l'aide d'un masque approprié, la couche 38 servant de couche d'arrêt à cette gravure.

On effectue alors le remplissage des trous de contact 42 à l'aide d'un matériau conducteur 44. La présence de la couche conductrice 38 facilite la prise de contact au fond des trous de contacts 42. Par ailleurs, la couche de shunt assure un bon germe pour la croissance de la couche de métallisation 44.

Ce matériau conducteur 44 est en particulier déposé sélectivement comme la couche conductrice 38. Le matériau 44 peut être un siliciure formé par siliciuration locale de la couche 38 ou un métal. Dans ce dernier cas, on utilise en particulier le tungstène déposé à basse température par LPCVD comme décrit dans l'article de V.V Lee cité précédemment.

Les figures 4 et 5 représentent des situations extrêmes de prise de contact électrique sur les régions de source et drain des transistors en utilisant le procédé selon l'invention. Sur ces figures 4 et 5, les éléments de circuit portent les mêmes références que précédemment, complétées des lettres a et b respectivement.

Dans ces situations extrêmes, le contact électrique est assuré via les couches épitaxiées 28a, 28b de silicium, 29a ou 29b de siliciure et 38a ou 38b de shunt. En effet, les couches de shunt 38a épousent parfaitement les contours de la couche 29a et par conséquent ceux de la couche conductrice 28a, ce qui constitue ainsi une bonne protection des diodes de source et drain en bordure de l'oxyde de champ 4a ou 4b.

Par ailleurs, l'empilement de ces couches permet la réalisation de contacts 44a et 44b débordants, sans avoir à utiliser d'étape supplémentaire et en particulier une implantation ionique à l'intérieur des trous de contact 42a et 42b, formés respectivement dans la couche d'isolement 40a et 40b.

La description donnée précédemment n'a bien entendu été donnée qu'à titre illustratif, toutes modifications sans pour autant sortir du cadre de l'invention pouvant être envisagées. En particulier la nature des différentes couches, leur technique de dépôt et leur technique de gravure peuvent être modifiées. Par ailleurs, certaines couches peuvent être supprimées sans pour autant affecter les propriétés des transistors obtenus. Ceci est en particulier le cas de la couche de shunt 38. En son absence, les contacts débordants (figures 4 et 5) seront un peu plus difficiles à réaliser.

**Revendications**

1. Procédé de fabrication d'un circuit intégré sur un substrat semi-conducteur, comportant des transistors MIS dont les sources (18, 32) et les drains (20, 34) consistent en des doubles jonctions et dont les grilles sont formées dans une couche semi-conductrice, comprenant une première implantation d'ions (14) d'un type de conductivité déterminé, dans le substrat, à une dose déterminée, pour y former des premières jonctions de source (18) et drain (20), puis une seconde implantation d'ions (30) du même type que la première, à une dose plus élevée que celle de la première implantation pour former lesdites doubles jonctions, ce procédé comprenant les étapes successives suivantes :

a) - réalisation d'isolations électriques latérales (4) des transistors dans ledit substrat,

b) - dépôt d'une couche d'un premier isolant (6) au moins entre les isolations latérales sur ledit substrat,

c) - dépôt, sur la structure obtenue en b), d'une couche semi-conductrice (8) apte à être dopée et gravée sélectivement par rapport auxdites isolations latérales, au premier isolant et à des bandes d'espacement (24) isolantes à réaliser,

d) - réalisation sur la couche semi-conductrice, d'un masque (10a) en au moins un matériau apte à être gravé sélectivement par rapport auxdites isolations latérales, au premier isolant, à la couche semi-conductrice, à un second matériau (26) isolant et auxdites bandes d'espacement isolantes à réaliser, masquant les grilles des transistors à réaliser dans la couche semi-conductrice,

e) - première implantation d'ions (14) dans la couche semi-conductrice (8) et dans le substrat (2) non masqués pour former les premières jonctions de source (18) et drain (20) des transistors,

f) - réalisation desdites bandes d'espacement isolantes (24) sur les flancs du masque (10a),

g) - gravure de la couche semi-conductrice (8) pour en éliminer les régions non recouvertes par le masque et lesdites bandes d'espacement isolantes formant ainsi la grille (8a) des transistors,

h) - isolation (26) des flancs gravés de la couche semi-conductrice avec le second isolant,

i) - élimination du masque (10a) par gravure sélective par rapport auxdites isolations latérales (4), à la couche de premier isolant (6), à la couche semi-conductrice (8), à l'isolation des flancs gravés et par rapport auxdites bandes d'espacement (24),

j) - élimination des régions du premier isolant mises à nu lors de l'étage g) par gravure sélective par rapport à la couche semi-conductrice (8) et par rapport au substrat,

k) - dépôt par une technique épitaxiele d'une couche conductrice (28) sur les régions de source (18) et drain (20) mises à nu au cours de l'étape (j) et sur la grille (8a) des transistors, de façon sélective par rapport auxdites isolations latérales (4), auxdites bandes d'espacement (24) et par rapport à l'isolation (26) des flancs gravés,

l) - seconde implantation d'ions (30) dans la couche conductrice (28) et dans les régions de source et drain, de sorte que les doubles jonctions y soient formées en partie,

m) - réalisation des connexions électriques du circuit intégré.

2. Procédé selon la revendication 1, caractérisé en ce que l'on dépose un matériau conducteur (38), entre les étapes l) et m), de façon sélective sur la couche conductrice (28) par rapport auxdites bandes d'espacement, auxdites isolations latérales et au second isolant pour former les shunts des grilles, des sources et des drains.

3. Procédé selon la revendication 2, caractérisé en ce que l'on dépose, entre la couche conductrice (28) et le matériau conducteur (38), une couche conductrice intermédiaire (29) de façon sélective sur cette couche épitaxiée par rapport aux bandes d'espacement, aux isolations latérales et au second isolant.

4. Procédé selon l'une quelconque des revendications précédentes, caractérisé en ce que le masque (10a) est formé d'un empilement de deux matériaux (13, 11), le matériau (11) formé directement sur la couche semi-conductrice (8) étant apte à être gravé sélectivement par rapport au premier isolant, à la couche semi-conductrice, au second matériau (26) isolant, auxdites bandes d'espacement isolantes et aux isolations latérales.

5. Procédé selon l'une quelconque des revendications précédentes, caractérisé en ce que l'étape m) consiste à déposer sur l'ensemble de la structure obtenue en l) une couche d'isolement (40) ; à former des trous de contact (42) dans cette couche d'isolement en regard des grilles (8a), des sources (18, 32) et des drains (20, 34) à connecter ; à déposer un matériau conducteur (44) de façon sélective dans les trous de contact (42) par rapport à la couche d'isolement (40).

6. Procédé selon l'une quelconque des revendications 2 à 5, caractérisé en ce que le matériau conducteur déposé de façon sélective sur la couche conductrice et/ou celui déposé dans les trous de contact sont du tungstène déposé par LPCVD, du silicium, un siliciure ou un métal choisi parmi le platine, le palladium et le cuivre.

7. Procédé selon l'une quelconque des revendications précédentes, caractérisé en ce que le masque (10a) est formé d'une couche de $Si_3N_4$ (11) et d'une couche de $SiO_2$ (13), la couche de $Si_3N_4$ étant formée directement sur la couche semi-conductrice.

8. Procédé selon l'une quelconque des revendications précédentes, caractérisé en ce que l'on effectue un recuit du circuit après la seconde implantation pour faire diffuser les ions implantés et les activer.

9. Procédé selon l'une quelconque des revendications précédentes, caractérisé en ce que le substrat (2), la couche semi-conductrice (8) et la couche conductrice épitaxiée (28) sont en silicium.

10. Procédé selon l'une quelconque des revendications précédentes, caractérisé en ce que le substrat (2) et la couche semi-conductrice (8) sont en silicium et en ce que la couche conductrice (28) est formée au moins en partie par un siliciure d'un métal de transition.

11. Procédé selon la revendication 10, caractérisé en ce que le métal de transition est le titane ou le cobalt.

**Patentansprüche**

1. Verfahren zur Herstellung einer integrierten Schaltung auf einem Halbleitersubstrat mit MIS-Transistoren, deren Sources (18, 32) und Drains (20, 34) aus doppelten Übergängen bestehen und deren Gates in einer Halbleiterschicht ausgebildet sind, eine erste Implantation (14) von Ionen eines bestimmten Konduktivitätstyps in das Substrat umfassend, mit einer bestimmten Dosis, um dort erste Source- und Drainübergänge (18 und 20) zu bilden, dann eine zweite Ionenimplantation (30) desselben Typs wie die erste, mit einer höheren Dosis als die erste Implantation, um die genannten doppelten Übergänge zu bilden, wobei dieses Verfahren die folgenden Schritte umfaßt:

   a) - Herstellen seitlicher elektrischer Isolationen (4) der Transistoren in dem genannten Substrat,
   b) - Abscheiden einer Schicht eines ersten Isolators (6) wenigstens zwischen den seitlichen Isolationen auf dem genannten Substrat,
   c) - Abscheiden - auf der in b) erhaltenen Struktur - einer Halbleiterschicht (8), die geeignet ist, dotiert und selektiv geätzt zu werden in bezug auf die genannten seitlichen Isolationen, den ersten Isolator und herzustellende isolierende Abstandsstreifen (24),
   d) - Herstellen - auf der Halbleiterschicht - einer Maske (10a), aus wenigstens einem Material, das geeignet ist, selektiv geätzt zu werden in bezug auf die genannten seitlichen Isolationen, den erste Isolator, die Halbleiterschicht, ein zweites isolierendes Material (26) und die genannten herzustellenden isolierenden Abstandsstreifen (24), die die Gates der herzustellenden Transistoren in der Halbleiterschicht maskieren,
   e) - erste Ionenimplantation (14) in die Halbleiterschicht (8) und in das unmaskierte Substrat (2), um die ersten Source- und Drainübergänge (18 und 20) der Transistoren zu bilden,
   f) - Herstellen der genannten isolierenden Abstandsstreifen (24) auf den Flanken der Maske (10a),
   g) - Ätzen der Halbleiterschicht (8), um ihre nicht durch die Maske abgedeckten Bereiche zu eliminieren und die genannten isolierenden Abstandsstreifen sowie das Gate 8a des Transistors bilden,
   h) - Isolieren der geätzten Flanken der Halbleiterschicht mit dem zweiten Isolator (26),
   i) - Eliminieren der Maske (10a) durch selektives Ätzen in bezug auf die genannten seitlichen Isolationen (4), die Schicht des ersten Isolators (6), die Halbleiterschicht (8), die Isolation der geätzten Flanken, und in bezug auf die genannten Abstandsstreifen (24),
   j) - Eliminieren der in Schritt g) freigelegten Bereiche des ersten Isolators durch selektives Ätzen in bezug auf die Halbleiterschicht (8) und in bezug auf das Substrat,
   k) - Abscheiden einer leitenden Schicht (28) mittels einer Epitaxietechnik auf den Bereichen der Source (18) und des Drains (20), freigelegt in Schritt j), und auf dem Gate (8a) der Transistoren, selektiv in bezug auf die genannten seitlichen Isolationen (4), die genannten Abstandsstreifen (24) und in bezug auf die Isolation (26) der geätzten Flanken,
   l) - zweite Ionenimplantation (30) in die leitende Schicht (28) und in die Source- und Drainbereiche, damit dort die doppelten Übergänge teilweise gebildet werden,
   m) - Herstellen der elektrischen Verbindungen der integrierten Schaltung.

2. Verfahren nach Anspruch 1, dadurch gekennzeichnet, daß man zwischen den Schritten 1) und m) auf der leitenden Schicht (28) ein leitendes Material (38) abscheidet, selektiv in bezug auf den genannten Abstandstreifen, den genannten seitlichen Isolationen und dem zweiten Isolator, um die Shunts bzw. Nebenschlüsse der Gates, der Sources und der Drains zu bilden.

3. Verfahren nach Anspruch 2, dadurch gekennzeichnet, daß man zwischen der leitenden Schicht (28) und dem leitenden Material (38) auf dieser Schicht (28) eine leitende Zwischenschicht (29) abscheidet, selektiv in bezug auf die Abstandsstreifen, die seitlichen Isolationen und den zweiten Isolator.

4. Verfahren nach einem der vorangehenden Ansprüche, dadurch gekennzeichnet, daß die Maske (10a) durch eine Aufeinanderschichtung von zwei Materialien (13, 11) gebildet wird, wobei das direkt auf der Halbleiterschicht (8) gebildete Material (11) selektiv geätzt werden kann in bezug auf den ersten Isolator, die Halbleiterschicht, das zweite isolierende Material (26), die genannten isolierenden Abstandsstreifen und die seitlichen Isolationen.

5. Verfahren nach einem der vorangehenden Ansprüche, dadurch gekennzeichnet, daß der Schritt m) darin besteht, auf der gesamten in l) erhaltenen Struktur eine Isolierschicht (40) abzuscheiden; in dieser Isolierschicht gegenüber den anzuschließenden Gates (8a), Sources (18, 32) und Drains (20, 34) Kontaktlöcher (42) zu bilden; in den Kontaktlöchern (42) in bezug auf die Isolierschicht (40) selektiv ein leitendes Material (44) abzuscheiden.

6. Verfahren nach einem der Ansprüche 2 bis 5, dadurch gekennzeichnet, daß das selektiv auf der leitenden Schicht abgeschiedene Material und/oder das in den Kontaktlöchern abgeschiedene Material mittels LPCVD abgeschiedenes Wolfram, Silicium, ein Silicid oder ein unter Platin, Palladium und Kupfer ausgewähltes Metall ist.

7. Verfahren nach einem der vorangehenden Ansprüche, dadurch gekennzeichnet, daß die Maske (10a) durch eine $Si_3N_4$-Schicht (11) und eine $SiO_2$-Schicht (13) gebildet wird, wobei die $Si_3N_4$-Schicht direkt auf der Halbleiterschicht gebildet wird.

8. Verfahren nach einem der vorangehenden Ansprüche, dadurch gekennzeichnet, daß man nach der zweiten Implantation ein Tempern der Schaltung durchführt, damit die implantierten Ionen diffundieren und aktiviert werden.

9. Verfahren nach einem der vorangehenden Ansprüche, dadurch gekennzeichnet, daß das Substrat (2), die Halbleiterschicht (8) und die leitende Schicht (28) aus Silicium sind.

10. Verfahren nach einem der vorangehenden Ansprüche, dadurch gekennzeichnet, daß das Substrat (2) und die Halbleiterschicht (8) aus Silicium sind, und dadurch, daß die leitende Schicht (28) wenigstens teilweise durch ein Silicid eines Übergangsmetalls gebildet wird.

11. Verfahren nach Anspruch 10, dadurch gekennzeichnet, daß das Übergangsmetall Titan oder Kobalt ist.

## Claims

1. Process for the production of an integrated circuit on a semiconductor substrate having MIS transistors, whose sources (18, 32) and drains (20, 34) consist of double junctions and whose gates are formed in a semiconducting layer, comprising a first implantation (14) of ions of a given conductivity type in the substrate and at a given dose, in order to form there the first source (18) and drain (20) junctions, followed by a second implantation (30) of ions of the same type as the first, at a higher dose than that of the first implantation in order to form said double junctions, said process comprising the following successive stages:

    a) production of the lateral electrical insulations (4) of the transistors in said substrate,
    b) deposition of a layer of a first insulant (6) at least between the lateral insulations,
    c) deposition, on the structure obtained in b), of a semiconducting layer (8), which can be selectively doped and etched with respect to the said lateral insulations, the first insulant and the insulating spacing strips (24) to be produced,
    d) production, on the first semiconducting layer, of a mask (10a) of at least one material which can be selectively etched with respect to the said lateral insulations, the first insulant, the semiconducting layer, a second insulating material (26) and said insulating spacing strips to be produced masking the gates of the transistors to be produced in the semiconducting layer,
    e) first implantation (14) of ions in the semiconducting layer (8) and in the substrate (2), which are not masked, in order to form the first source (18) and drain (20) junctions of the transistors,
    f) production of said insulating spacing strips (24) on the mask (10a) edges,
    g) etching of the semiconductor layer (8) in order to eliminate therefrom the regions not covered by the mask and said insulating spacing strips thus forming the gate (8a) of the transistors,
    h) insulation (26) of the etched edges of the semiconductor layer with the second insulant,
    i) elimination of the mask (10a) by selective etching with respect to said lateral insulations (4), the first insulant layer (6), the semiconductor layer (8), the insulation of the etched edges and with respect to said spacing strips (24),
    j) elimination of the regions of the first insulant exposed during stage g) by selective etching with respect to the semiconductor layer (8) and with respect to the substrate,
    k) deposition by an epitaxial process of a conductive layer (28) on the source (18) and drain (20) regions exposed during stage j) and on the gate (8a) of the transistors in a selective manner with respect to said lateral insulations (4), to said spacing strips (24) and to the insulation (26) of the etched edges,

l) second implantation of ions (30) in the conductive layer (28) and in the source and drain regions, in such a way that the double junctions are in part formed there,

m) production of the electrical connections of the integrated circuit.

2. Process according to claim 1, characterized in that a conductive material (38) is deposited between stages 1) and m) in selective manner on the conductive layer (28) with respect to the said spacing strips, the lateral insulations and the second insulant in order to form the gate, source and drain shunts.

3. Process according to claim 2, characterized in that, between the conductive layer (28) and the conductive material (38) is deposited an intermediate conductive layer (29) in selective manner on said epitaxied layer with respect to the spacing strips, the lateral insulations and the second insulant.

4. Process according to any one of the preceding claims, characterized in that the mask (10a) is formed by a stack of two materials (13, 11), the material (11) formed directly on the semiconducting layer (8) being selectively etchable with respect to the first insulant, the semiconducting layer, the second insulating material (26), said insulating spacing strips and the lateral insulations.

5. Process according to any one of the preceding claims, characterized in that the stage m) consists of depositing on the complete structure obtained in l) an insulating layer (40), forming contact holes (42) in said insulating layer facing the gates (8a), the sources (18, 32) and the drains (20, 34) to be connected, depositing a conductive material (44) in selective manner in the contact holes (42) with respect to the insulating layer (40).

6. Process according to any one of the claims 2 to 5, characterized in that the conductive material selectively deposited on the conductive layer and/or that deposited in the contact holes are LPCVD-deposited tungsten, silicon, a silicide or a metal chosen from among platinum, palladium and copper.

7. Process according to any one of the preceding claims, characterized in that the mask (10a) is formed from a $Si_3N_4$ layer (11) and a $SiO_2$ layer (13), the $Si_3N_4$ layer being formed directly on the semiconducting layer.

8. Process according to any one of the preceding claims, characterized in that the circuit is annealed following the second implantation in order to diffuse and activate the implanted ions.

9. Process according to any one of the preceding claims, characterized in that the substrate (2), the semiconducting layer (8) and the epitaxied conductive layer (28) are of silicon.

10. Process according to any one of the preceding claims, characterized in that the substrate (2) and the semiconducting layer (8) are of silicon and that the conductive layer (28) is formed at least partly by a silicide of a transition metal.

11. Process according to claim 10, characterized in that the transition metal is titanium or cobalt.

FIG. 1 A

FIG. 1 B

FIG. 1 C

FIG.1D

FIG.1E

FIG.1F

EP 0 420 748 B1

FIG. 1 G

FIG. 1 H

FIG. 2

14

FIG. 3

FIG. 4

FIG. 5